# EUROPEAN PATENT SPECIFICATION

(11) **EP 1 962 291 B1**
(45) Date of publication and mention of the grant of the patent: **13.04.2011**
(21) Application number: 08101745.1
(22) Date of filing: 19.02.2008
(51) Int. Cl.: G11C 16/22

(54) **Prevention of unwanted I2C read/write operations**
Verhinderung unerwünschter I2C-Schreib-/Lese-Operationen
Prévention d'opérations d'écriture/lecture I2C indésirables

(30) Priority: 23.02.2007 TR 200701135
(43) Date of publication of application: 27.08.2008
(73) Proprietor: Vestel Elektronik Sanayi ve Ticaret A.S., 45030 Manisa (TR)
(72) Inventor: Cetin, Huseyin Erturk, 45030 Manisa (TR)
(74) Representative: Cayli, Hülya

(56) References cited:
- EP-A- 0 155 113

## Description

### Technical Field

The present invention relates to providing protection for electronic devices, which perform data read or write operations and which are connected to 12C data line (inter-integrated circuit), from unwanted read/write operations.

### Prior Art

In the known I2C line, the electronic devices connected to 12C line like non-volatile memory devices such as EEPROM (electrically erasable programmable read only memory) have "write protect" pins for preventing unwanted read/ write operations. In order to prevent data corruption, some micro controllers have "write protect" pins assigned to this aim, and even some micro controllers have 12C line outputs assigned for write protection where "Logical zero" signal on these protection pins is required for the read/write operations to be performed.

In many systems, an exclusive output is provided which is allocated by a microcontroller for the prevention of inadvertent read/write operations. During operation period of an electronic device connected to 12C line, any noise and unbalanced voltages which may occur on the 12C data line can cause the micro controller to recognize the device connected to 12C line as "free" and to delete all information within it. In particular, when the system is turned on and turned off, the imbalances in the non-volatile memory voltage cause micro controller to accept the non-volatile memory as "free" and to delete the information in this non- volatile memory.

Among the solution techniques regarding to this subject, the systems which measure the voltage of the data line connected to data line and which regulate the said imbalance in case of a voltage imbalance are available. In the patent application document no. US 6198661 is disclosed a system which measures the voltage imbalance occurring in a non-volatile memory. Furthermore; a circuit providing data protection in a volatile memory (RAM (Random Access Memory)) is described in the document no. US 04580039.

Although there are known solutions related to data validation during read/ write operations as well, these systems fail to find a practical and permanent solution to the unwanted read/ write operations which might occur due to voltage irregularity. Since the power supplies of many circuit elements connected to data line are common, in case of a voltage irregularity, to ground the voltage supply of the non- volatile memory will be useless as it will ground the supplies of other circuit elements as well.

EP 0 155 113 discloses circuitry for monitoring a power supply voltage level to disable a write enable signal for a memory when the voltage level drops below a predermined threshold level.

### Objective of Invention

The objective of the present invention is to prevent the unwanted read/write operations within an electronic device connected to 12C, by grounding serial clock line (SCL) connected to said electronic device in case of voltage irregularity.

This objective is achieved by the method of claim 1 and by the apparatus of claim 6.

### Brief Disclosure of the Drawings

The figures related to the system of the present invention are illustrated in the accompanying drawings, wherein:
Fig. 1 is the flow chart showing the principle of operation of the present invention.
Fig. 2 is the circuit diagram of the electronic implementation of the present invention.
Fig. 3 is the graphical view of the status of the present invention at the normal voltage level.
Fig. 4 is the graphical view of the reaction of the present invention to voltage irregularity.
Fig. 5 is the graphical view of the application performed by changing the threshold voltage in the invention.

The descriptions of the abbreviations and references shown in the figures are illustrated in hereunder:
Vcc: Data line (supply) voltage
SCL: Serial clock line
Q1: the first transistor
Q2: the second transistor
R1: the first resistor
R2: the second resistor
R3: the third resistor
R4: the fourth resistor
R5: the fifth resistor
R6: the sixth resistor

### Disclosure of Invention

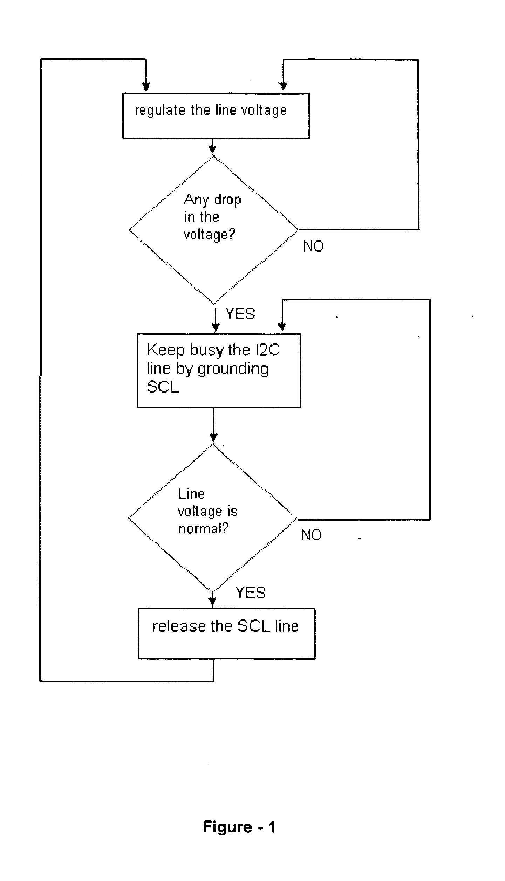

According to the present invention a circuit monitors the voltage of the 12C data line (Vcc) continuously, and in case of an error, the circuit grounds the serial clock line (SCL) of at least one electronic device accordingly. The principle of the said invention is illustrated in Figure 1. The voltage of data line is consistently monitored, and in case of a drop at the voltage of data line, serial clock line is grounded, and the monitoring process is carried on as long as there is no drop, and when the voltage of the data line returns to a determined level, the serial clock line is released, but in the event that it does not return, it is kept busy by being grounded.

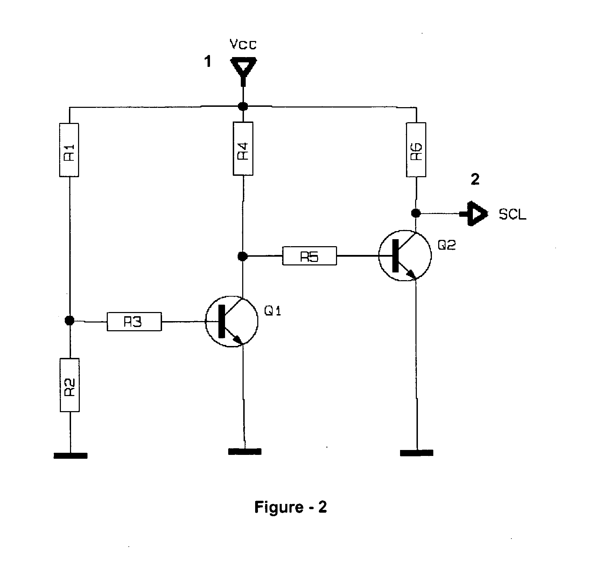

The circuit diagram of the present system is illustrated as the example shown in Figure 2, where the first and second resistors (R1 and R2) determine a threshold voltage for enabling/disabling SCL connected to an electronic device, the third and the fifth resistors (R3 and R5) serve as a current limiter for the first and second transistors (Q1 and Q2), respectively, the value of first and second resistors are pre-determined in the site of manufacturer. The system is connected to data line supply voltage (Vcc) through the input 1 and to the serial clock line (SCL) through input 2.

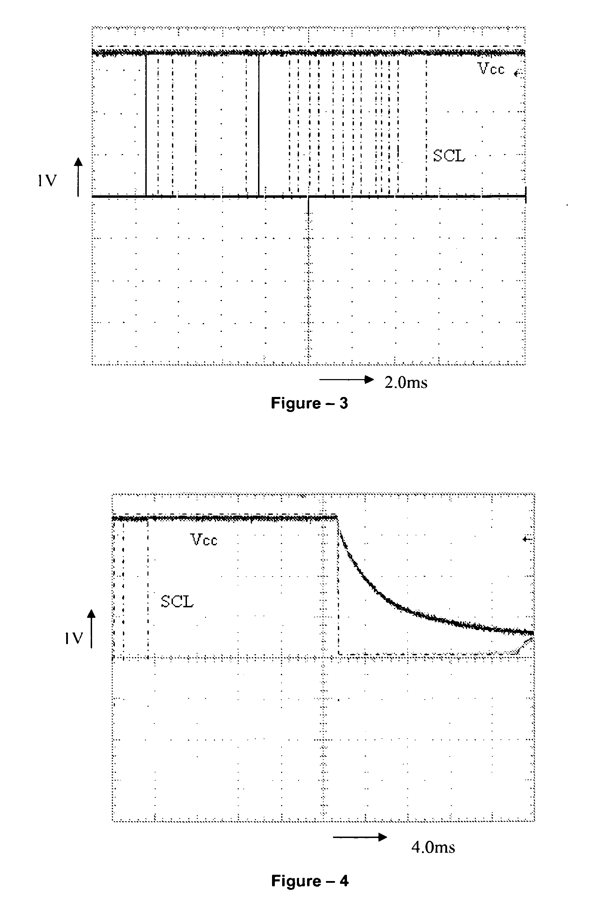

The graphic of the time-voltage amplitude of a data line which exchanges information and to which the present invention is connected under the normal operating conditions is illustrated in Figure 3. In the exemplary circuit made in Figure 2 for this example, the circuit elements have been selected as R1: 3900 ohm, R2: 910 ohm, R3: 1000 ohm, R4: 4700 ohm, R5: 1000 ohm, R6:12000 ohm, respectively and the transistors Q1 and Q2 as BC848B.

The base voltage of the first transistor (Q1) is 0.7 volts under the conditions observed in the graphic of the time-voltage amplitude shown in Figure 3, and this transistor (Q1) is on. Due to the voltage drop on the resistance (R4) created by the collector current of this transistor (Q1) when the first transistor (Q1) is on, the base voltage of the second transistor (Q2) is low, that is to say, Q2 is off. In such a case, the second transistor has no impact on the serial clock line (SCL).

When the data line voltage decreases below a predetermined level under the normal operating conditions, the base voltage of the first transistor (Q1) drops and turns off this transistor (Q1). The off state of the first transistor (Q1) turns on the second transistor (Q2) and grounds the serial clock line (SCL) and keeps it busy. As seen in Figure 4, when the system faces a voltage irregularity, it grounds the serial clock line. Since the data read/write operation to an electronic device(circuit element in this condition) is provided by SCL, data read/write is prevented when the serial clock line is grounded, no read/write operation can be performed on the band data line to which the system of the present invention is connected.

When the data line voltage (Vcc) rises to predetermined threshold level back, the first transistor (Q1) is turned on again, the second transistor (Q2) being off, and the serial clock line is resumed (grounding is over).

The present invention can be used not only with the non-volatile memories such as EEPROM but also other circuit elements connected to the 12C line (e.g. video matrix switch, audio processor). The threshold voltage can be changed for the circuit elements by adjusting the first and the second resistor values (R1 and R2) in Figure 2. The threshold value can be either predetermined by the producer before or adjusted by the user.

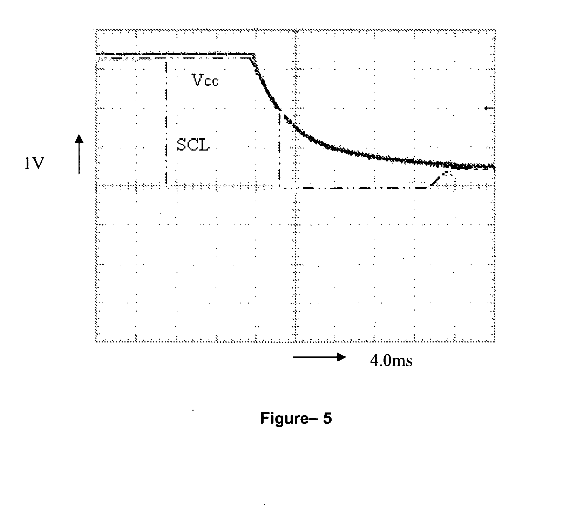

For instance, R2 is selected as 910 ohm in the circuit used in the graphic shown in Figure 4. When the value of R2 is replaced by 1600 ohm, the level of the threshold voltage will be decreased, and the present invention will not keep busy the serial data line (SCL) until a certain drop at voltage value as it is shown in the graphic in Figure 5.

## Claims

1. A method for prevention of unwanted read/write operations in an I2C system, which read/write operations otherwise might occur in a circuit element connected to an I2C data line;
wherein the said method comprises the steps of:
• determining a voltage threshold level for said I2C data line;
• continuously measuring a voltage of said I2C data line;
• disabling a serial clock line (SCL) of said circuit element when said I2C data line voltage decreases below said threshold level.

2. A method according to claim 1, **characterized in that** it releases said serial clock line (SCL) of said circuit element when said I2C data line voltage exceeds said threshold level.

3. A method according to Claim 1, **characterized in that** the said threshold level is determined in the site of manufacturer.

4. A method according to Claim 1, **characterized in that** said circuit element is a non-volatile memory.

5. A method according to Claim 4, **characterized in that** the said non-volatile memory is an EEPROM.

6. An I2C system having means for the prevention of unwanted read/write operations which otherwise might occur at a circuit element connected to an I2C data line, said means comprising:
• at least two resistors (R1, R2) connected in series between said I2C data line and a reference potential and forming a voltage divider, to determine a threshold voltage level for said I2C data line;
• at least one first transistor (Q1) switched on/off in accordance with the output of said voltage divider
• at least one second transistor (Q2) responsive to the switching on/off of said at least one first transistor (Q1) and which disables read/write operation of said circuit element by grounding a serial clock line (SCL) of said circuit element when said I2C data line voltage level is below said threshold voltage level for said I2C data line.

7. A system according to Claim 6, **characterized in that** the said threshold voltage level is a fixed value predetermined by producer.

8. A system according to Claim 6, **characterized in that** said circuit element is a non-volatile memory.

9. A system according to Claim 8, **characterized in that** said non-volatile memory is an EEPROM.

## Patentansprüche

1. Verfahren zum Verhindern ungewollter Lese-/Schreibvorgänge in einem I2C-System, welche Lese-/Schreibvorgänge andernfalls in einem Schaltungselement auftreten könnten, das an eine I2C-Datenleitung angeschlossen ist;
wobei das Verfahren die folgenden Schritte umfasst:
• Bestimmen eines Spannungsschwellenpegels für die I2C-Datenleitung;
• kontinuierliches Messen einer Spannung der I2C-Datenleitung;
• Abschalten einer seriellen Taktleitung (SCL) des Schaltungselements, wenn die Spannung der I2C-Datenleitung unter den Schwellen pegel sinkt.

2. Verfahren nach Anspruch 1, **dadurch gekennzeichnet, dass** die serielle Taktleitung (SCL) des Schaltungselements freigegeben wird, wenn die I2C-Datenleitung den Schwellenpegel überschreitet.

3. Verfahren nach Anspruch 1, **dadurch gekennzeichnet, dass** der Schwellenpegel in der Herstellerfertigungsstätte bestimmt wird.

4. Verfahren nach Anspruch 1, **dadurch gekennzeichnet, dass** es sich bei dem Schaltungselement um einen nichtflüchtigen Speicher handelt.

5. Verfahren nach Anspruch 4, **dadurch gekennzeichnet dass** der nichtflüchtige Speicher ein EEPROM ist.

6. I2C-System mit Einrichtungen zum Verhindern ungewollter Lese-/Schreibvorgänge, die andernfalls in einem Schaltungselement auftreten könnten, das an eine I2C-Datenleitung angeschlossen ist, wobei die Einrichtungen umfassen:
• mindestens zwei Widerstände (R1, R2), die zwischen der I2C-Datenleitung und einem Referenzpotential in Reihe geschaltet sind und einen Spannungsteiler bilden, um einen Schwellenspannungspegel für die I2C-Datenleitung zu bestimmen;
• mindestens einen ersten Transistor (Q1), der in Übereinstimmung mit dem Ausgang des Spannungsteilers ein-/ausgeschaltet wird;
• mindestens einen zweiten Transistor (Q2), der auf das Ein-/Ausschalten des mindestens einen ersten Transistors (Q1) anspricht und einen Lese/Schreibvorgang des Schaltungselements ausschaltet, indem eine serielle Taktleitung (SCL) des Schaltungselements an Masse gelegt wird, wenn der Spannungspegel der I2C-Datenleitung unter dem Schwellenspannungspegel für die I2C-Datenleitung liegt.

7. System nach Anspruch 6, **dadurch gekennzeichnet, dass** es sich bei dem Schwellenspannungspegel um einen vom Hersteller bestimmten festen Wert handelt.

8. System nach Anspruch 6, **dadurch gekennzeichnet, dass** es sich bei dem Schaltungselement um einen nichtflüchtigen Speicher handelt.

9. System nach Anspruch 8, **dadurch gekennzeichnet, dass** der nichtflüchtige Speicher ein EEPROM ist.

## Revendications

1. Procédé de prévention d'opérations de lecture/ écriture indésirables dans un système I2C, lesquelles opérations de lecture/écriture pouvant autrement intervenir dans un élément de circuit connecté à une ligne de données I2C;
dans lequel ledit procédé comprend les étapes suivantes :
- la détermination d'un niveau de seuil de tension pour ladite ligne de données I2C;
- la mesure continue d'une tension de ladite ligne de données I2C ;
- la désactivation d'une ligne d'horloge sérielle (SCL) dudit élément de circuit lorsque la tension de ladite ligne de données I2C descend en dessous dudit niveau de seuil.

2. Procédé selon la revendication 1, **caractérisé en ce qu'**il active ladite ligne d'horloge sérielle (SCL) dudit élément de circuit lorsque la tension de ladite ligne de données I2C est au-dessus dudit niveau de seuil.

3. Procédé selon la revendication 1, **caractérisé en ce que** ledit niveau de seuil est déterminé sur le site du fabriquant.

4. Procédé selon la revendication 1, **caractérisé en ce que** ledit élément de circuit est une mémoire non volatile.

5. Procédé selon la revendication 4, **caractérisé en ce que** ladite mémoire non volatile est une EEPROM.

6. Système I2C possédant des moyens de prévention d'opérations de lecture/écriture indésirables pouvant autrement intervenir au niveau d'un élément de circuit connecté à une ligne de données I2C, lesdits moyens comprenant :
- au moins deux résistances (R1, R2) connectées en série entre ladite ligne de données I2C et un potentiel de référence et formant un diviseur de tension, pour déterminer un niveau de seuil de tension pour ladite ligne de données I2C ;
- au moins un premier transistor (Q1) mis en marche/arrêt selon la sortie dudit diviseur de tension ;
- au moins un second transistor (Q2) répondant à la mise en marche/arrêt dudit au moins un premier transistor (Q1) et qui désactive l'opération de lecture/écriture dudit élément de circuit en mettant à la terre une ligne d'horloge sérielle (SCL) dudit élément de circuit lorsque la tension de ladite ligne de données I2C est en dessous dudit niveau de seuil de tension pour ladite ligne de données I2C.

7. Système selon la revendication 6, **caractérisé en ce que** ledit niveau de seuil de tension est une valeur fixe prédéterminée par le producteur.

8. Système selon la revendication 6, **caractérisé en ce que** ledit élément de circuit est une mémoire non volatile.

9. Système selon la revendication 8, **caractérisé en ce que** ladite mémoire non volatile est une EEPROM.
